Europäisches Patentamt

European Patent Office

Office européen des brevets

(19)

(11) Veröffentlichungsnummer : **0 177 873**
**B1**

(12)

# EUROPÄISCHE PATENTSCHRIFT

(45) Veröffentlichungstag der Patentschrift :
**11.01.89**

(51) Int. Cl.⁴ : **G 03 D 3/10// G03F7/16**

(21) Anmeldenummer : **85112388.5**

(22) Anmeldetag : **01.10.85**

(54) **Walzenandruck- und -abhebeeinrichtung.**

(30) Priorität : **09.10.84 DE 3436980**
**28.08.85 DE 3530680**

(43) Veröffentlichungstag der Anmeldung :
**16.04.86 Patentblatt 86/16**

(45) Bekanntmachung des Hinweises auf die Patenterteilung : **11.01.89 Patentblatt 89/02**

(84) Benannte Vertragsstaaten :
**AT BE DE FR GB IT NL SE**

(56) Entgegenhaltungen :
**EP—A— 0 004 337**
**DE—A— 2 740 551**
**GB—A— 343 963**
**GB—A— 1 067 550**
**GB—A— 2 108 706**

(73) Patentinhaber : **HOECHST AKTIENGESELLSCHAFT**
**Postfach 80 03 20**
**D-6230 Frankfurt am Main 80 (DE)**

(72) Erfinder : **Heist, Hans**
**Am Hohen Stein 4**
**D-6200 Wiesbaden-Biebrich (DE)**
Erfinder : **Britzke, Sylvia**
**Eintrachstrasse 13**
**Eintrachtstrasse 13 (DE)**
Erfinder : **Töpfer, Dieter**
**Mühlstrasse 5**
**D-6209 Heidenrod 3 (DE)**
Erfinder : **Schörnig, Eberhard**
**Römerstrasse 9**
**D-6204 Taunusstein 4 (DE)**

EP 0 177 873 B1

## Beschreibung

Die Erfindung betrifft eine Walzenandruck- und -abhebeeinrichtung mit paarweise horizontal angeordneten oberen und unteren Walzen zum Transport von plattenförmigen Materialien und zum Abquetschen von an den plattenförmigen Materialien haftender Restflüssigkeit, mit je einem an jedem Achsenende jeder oberen Walze bezüglich der unteren Walze anhebbaren und absenkbaren Kugellager.

Bei einer derartigen, aus der DE-A-23 26 122 bekannten Einrichtung ragen die obere und die untere Walze eines Walzenpaares mit ihren Wellenzapfen auf jeder Seite in ein Gehäuse hinein. In diesem ist das untere Lager fest angeordnet, während das obere Lager um einen zur Lagerachse exzentrischen Zapfen schwenkbar ist. An seiner dem Zapfen gegenüber liegenden Seite ist das Lager mit einem Gelenk verbunden. Das Gelenk ist an ein unteres Ende eines Hebels angelenkt, der um einen waagerechten Zapfen schwenkbar ist. Dieser Zapfen ist in einer an der oberen Wandung des Gehäuses befestigten Konsole angeordnet. Auf der Oberseite des Gehäuses ragt ein Betätigungsgriff heraus, der mit dem schwenkbaren Hebel verbunden ist. Dieser Hebel und das Gelenk bilden eine Kniehebelanordnung, die in ihrer gestreckten Position die obere Walze gegen die untere Walze drückt und durch Umlegen des Betätigungsgriffes die obere Walze von der unteren abhebt. Mit einer Entlastungsfeder ist dafür gesorgt, daß die obere Walze in ihrer abgehobenen Lage festgehalten wird.

Bei dieser Einrichtung muß zum Abheben der oberen Walzen das vor längeren Stillstandzeiten, z. B. über Nacht oder über ein Wochenende erfolgen muß, um ein Festkleben der oberen Walzen an den unteren Walzen zu vermeiden, eine Vielzahl von Betätigungsgriffen bedient werden, da jedem Ende jeder oberen Walze ein separater Betätigungsgriff zugeordnet ist. Diese Bedienung ist umständlich und zeitraubend, so daß die Gefahr groß ist, diese Bedienung gelegentlich zu unterlassen. Verbleiben jedoch die Walzen der Walzenpaare über längere Stillstandzeiten aneinandergepreßt, so können die zuvor schon erwähnten Festklebungen und darüber hinaus Deformierungen ihrer Oberflächen eintreten, welche einen sicheren und schonenden Transport von plattenförmigen Materialien, insbesondere von Druckplatten, sowie eine einwandfreie Flüssigkeitsabquetschung vor allem bei waagerechten Verarbeitungsanlagen für solche plattenförmigen Materialien gefährden können.

Zur Vereinfachung der Bedienung einer Entwicklungsvorrichtung für Druckplatten ist aus der EP-A-0 004 337 eine Einrichtung bekannt, bei der zum Angriff an den Lagern der oberen Walzen je ein schwenkbarer Gabelkopf mit einem oberen und einem unteren Arm vorgesehen ist, dessen Schwenkachse parallel zur Druckplattentransportrichtung gerichtet ist. Die Lager sind über eine Kniehebelanordnung betätigbar, wobei der obere Arm des schwenkbaren Gabelkopfs im abgesenkten Zustand des Lagers von oben auf das Lager drückt und der untere Arm des Gabelkopfs das Lager im angehobenen Zustand stützt. Ein erstes Ende jeder Kniehebelanordnung steht in Verbindung mit dem Gabelkopf und ein zweites Ende jeder Kniehebelanordnung ist mit einer allen Kniehebelanordnungen gemeinsamen drehbaren Schaltwelle verbunden, die parallel zur Druckplattentransportrichtung gelagert ist. Mit dieser Einstelleinrichtung ist es zwar möglich, sämtliche oberen Walzen durch eine einzige Hebelbewegung anzuheben und abzusenken, jedoch ist der konstruktive Aufwand für die Kniehebelanordnung und die Gabelköpfe mit zwei Armen sehr groß.

Zum Stand der Technik gehört auch eine Einrichtung zum Entwickeln von Druckplatten mit paarweise angeordneten Rollen, deren Enden in Seitenschilden gelagert sind. Diese Seitenschilde sind so aufgeteilt und mittels einem, dem oberen Seitenschild zugeordneten Drehpunkt und entsprechenden Hubelementen derart ausgerüstet, daß der komplette obere Teil der Seitenschilder bzw. der Verarbeitungszone einschließlich aller oberen Walzen angehoben werden kann.

Diese Einrichtung ist gleichfalls verhältnismäßig aufwendig, insbesondere dann, wenn das Abheben einen nicht zu großen Kraftaufwand der Bedienungsperson erfordern soll. Außerdem kann diese Anordnung nicht für solche Einrichtungen verwendet werden, die eine Anzahl von Behandlungsstationen aufweisen, wobei jede Behandlungsstation als eine bauliche Einheit ausgebildet ist, die mit weiteren baulichen Einheiten in Modul-Bauweise zu der gesamten Einrichtung zusammengesetzt werden kann.

Aufgabe der Erfindung ist es, eine Einrichtung der eingangs beschriebenen Art so weiterzuentwickeln und zu verbessern, daß mit konstruktiv sehr einfachen Mitteln ein zuverlässiges Abheben und Absenken aller oberen von den bzw. auf die unteren Walzen mit sehr geringem Aufwand erreicht wird.

Diese Aufgabe wird erfindungsgemäß dadurch gelöst, daß die Kugellager in spangenförmigen Führungen vertikal geführt sind, die an den Innenseiten von Seitenschilden ortsfest angebracht sind, daß zwei, in Gleitlagern geführte Schiebeteile aus einem hochkantstehenden U-Profil mit unterem und oberem Steg und einer Wand, die an den jeweiligen Seitenschild angrenzt und Ausbrüche aufweist, durch die die Führungen ins Innere der Einrichtung hineinragen, um einen vorgegebenen Abstand hin- und herverschiebbar sind, daß der untere und obere Steg der Schiebeteile Aussparungen mit einer abgeschrägten Kante pro Aussparung enthält und daß die unteren Aussparungen gegenüber den oberen Aussparungen um den vorgegebenen Abstand versetzt sind.

Die Walzenandruck- und -abhebeeinrichtung ist bezüglich ihrer Längsachse, die senkrecht zu den Walzenachsen verläuft, symmetrisch ausgebildet, d. h. auf jeder Seite der Einrichtung ist ein Schiebeteil angeordnet, das mit einer Zahnstange ausgerüstet ist, die oberhalb des oberen Stegs an einem Verlängerungsstück an dem einen Ende des Schiebeteils angeordnet ist und des weiteren ist ein Zahnradsegment um eine im Seitenschild der Einrichtung gelagerte Achse schwenkbar und befindet sich im Eingriff mit der Zahnstange.

In Ausgestaltung der Erfindung ist ein Schwenkhebel mit der Achse des Zahnradsegments verbunden und die Schwenkbewegung des Schwenkhebels wird durch das Ineinandergreifen von Zahnradsegment und Zahnstange in eine Translationsbewegung des Schiebeteils umgesetzt. Dazu sind der untere und der obere Steg des Schiebeteils jeweils in einer Anzahl von Gleitlagern aus Kunststoff geführt, die an der Innenseite des zugehörigen Seitenschilds befestigt sind. Der Schiebeteil wird mittels des drehbar gelagerten Zahnradsegments, das im Eingriff mit der Zahnstange ist, in Transportrichtung der plattenförmigen Materialien hin- und herverschoben.

In Weiterbildung der Erfindung sind die abgeschrägten Kanten der unteren Aussparungen entgegen der Transportrichtung der plattenförmigen Materialien gerichtet und verlaufen die abgeschrägten Kanten der oberen Aussparungen in Transportrichtung. Dabei sind die Schrägen der Kanten schiefe Ebenen für die Kugellager bei der Verschiebung der Schiebeteile, wobei in der Andruckstellung die schrägen Kanten der Aussparungen des oberen Stegs die Kugellager durch die unteren Aussparungen drücken und die oberen Walzen auf die unteren Walzen anpressen und in der Abhebestellung die schrägen Kanten der Aussparungen des unteren Stegs die Kugellager anheben, die frei durch die oberen Aussparungen hindurchragen und die oberen von den unteren Walzen abheben. In kostengünstiger Weise sind die Schiebeteile als Stanz- und Biegeteile aus Blech gefertigt.

Der vorgegebene Abstand zwischen den Mittellinien einer unteren Aussparung und einer zugeordneten oberen Aussparung ist gleich dem Abstand bzw. gleich dem Verschiebeweg eines Schiebeteils. In weiterer Ausgestaltung der Erfindung besitzen die untereinander gleichgroßen Aussparungen eine Längsabmessung größer als der Außendurchmesser der Kugellager und ist die Höhe der Wand des Schiebeteils kleiner als der Außendurchmesser der Kugellager. Die Kugellager sitzen zweckmäßigerweise auf den Achsenenden der oberen Walzen auf und begrenzen diese seitlich.

Um den Walzenanpreßdruck auf eine durch die Einrichtung hindurchlaufende Platte mit sehr geringem Aufwand einstellen zu können, ist an dem oberen Steg, angrenzend an jede Aussparung, je ein Formteil mit einer Schräge lösbar befestigt und befindet sich zwischen der Unterseite des oberen Stegs und der Oberseite jedes Formteils eine Anzahl von Zwischenlagen mit vorgegebenen Dicken.

Durch die Verwendung von Schiebeteilen, die durch Stanzen und Biegen aus Blech hergestellt werden, werden die Vorteile eines konstruktiv einfachen Aufbaus, geringer Herstellungskosten und niedrigen Gewichts erzielt.

Die Erfindung wird im folgenden anhand zeichnerisch dargestellter Ausführungsbeispiele näher erläutert.

Es zeigen :

Fig. 1 eine schematische Draufsicht auf eine Ausführungsform der erfindungsgemäßen Einrichtung,

Fig. 2 eine Ansicht eines Ausschnitts mit zwei Walzenpaaren der Einrichtung nach Fig. 1 in der Andruckstellung,

Fig. 3 eine Ansicht gemäß Fig. 2, jedoch in der Abhebestellung der beiden Walzenpaare,

Fig. 4 eine Teilansicht im Schnitt längs der Linie B-B in Fig. 3,

Fig. 5 eine Ansicht eines Ausschnittes mit zwei Walzenpaaren einer weiteren Ausführungsform der Einrichtung, ähnlich zu derjenigen nach Fig. 2, in der Anpreßstellung der beiden Walzenpaare, und

Fig. 6a, 6b und 6c in vergrößerter Teilansicht ein Formteil und Zwischenlagen gemäß Fig. 5, sowie Draufsichten auf ein Formteil und eine Zwischenlage.

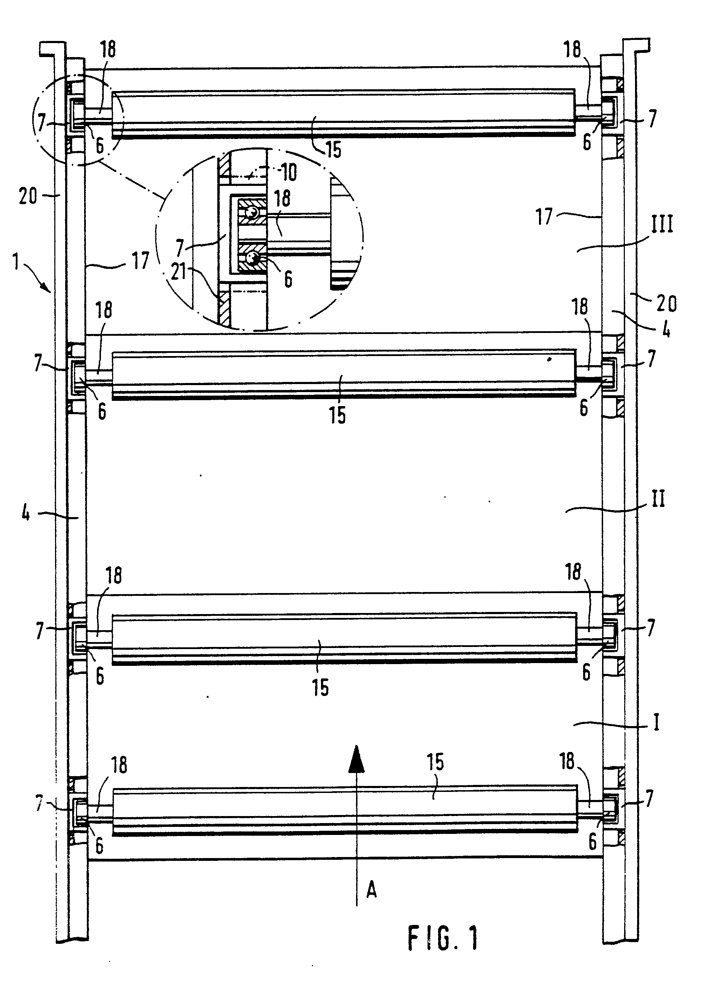

In der schematischen Draufsicht der Einrichtung 1 in Fig. 1 sind drei modulmäßig hintereinander angeordnete Verarbeitungsstationen I, II und III erkennbar, bei denen es sich beispielsweise in Transportrichtung A gesehen um eine Entwicklungsstation, eine Wässerungsstation und eine Station zum Aufbringen einer Schutzschicht auf die entwickelten und gewässerten Materialien, insbesondere Druckplatten, handeln kann. Die eigentlichen Bearbeitungselemente, wie Sprührohre, Rakeln und Bürstenwalzen sind in Fig. 1 aus Grunden der besseren Übersichtlichkeit weggelassen, nicht jedoch die zum Transport der Druckplatten durch die Einrichtung 1 notwendigen Walzenpaare, die auch das Abquetschen von Restflüssigkeit von den Druckplatten besorgen. Im einzelnen sind von diesen Walzenpaaren in der Draufsicht nur die oberen Walzen 15 erkennbar. Die Walzen 15 sind auf ihrer linken und rechten Seite mit je einem Kugellager 6 in einem Schiebeteil 17 gelagert, das gegenüber Seitenschilden 20 der Einrichtung 1 in Transportrichtung A hin- und herverschiebbar ist, wie später noch näher beschrieben werden wird. Das einzelne Schiebeteil 17 besteht aus einem hochkant stehenden U-Profil mit einem oberen und einem unteren Steg, die von einer Wand 21 des Schiebeteils 17 abgewinkelt in das Innere der Einrichtung 1 weisend, abstehen. In Fig. 1 ist in der Draufsicht der obere Steg 4 zu erkennen, der im Bereich der Kugellager 6, die auf den Achsenenden der Walzen 15 aufsitzen, jeweils eine obere Aussparung 10 aufweist. Jedes Kugellager 6 ist des weiteren noch in einer spangenförmigen Führung 7 vertikal zur Zeichenebene geführt. Die spangenförmigen Führungen 7 sind an den Innenseiten der Seitenschilde 20 der Einrichtung 1 befestigt. Der vergrösserte Detailausschnitt in Fig. 1 zeigt im Bereich der Aussparung 10 einen aufgebrochenen oberen Steg 4 sowie die Wand 21 des Schiebeteils 17. Die Einrichtung 1 ist symmetrisch aufgebaut, d. h. sie besitzt sowohl zur linken als auch zur rechten Seite je einen Schiebeteil 17, die weitgehend identisch ausgebildet sind.

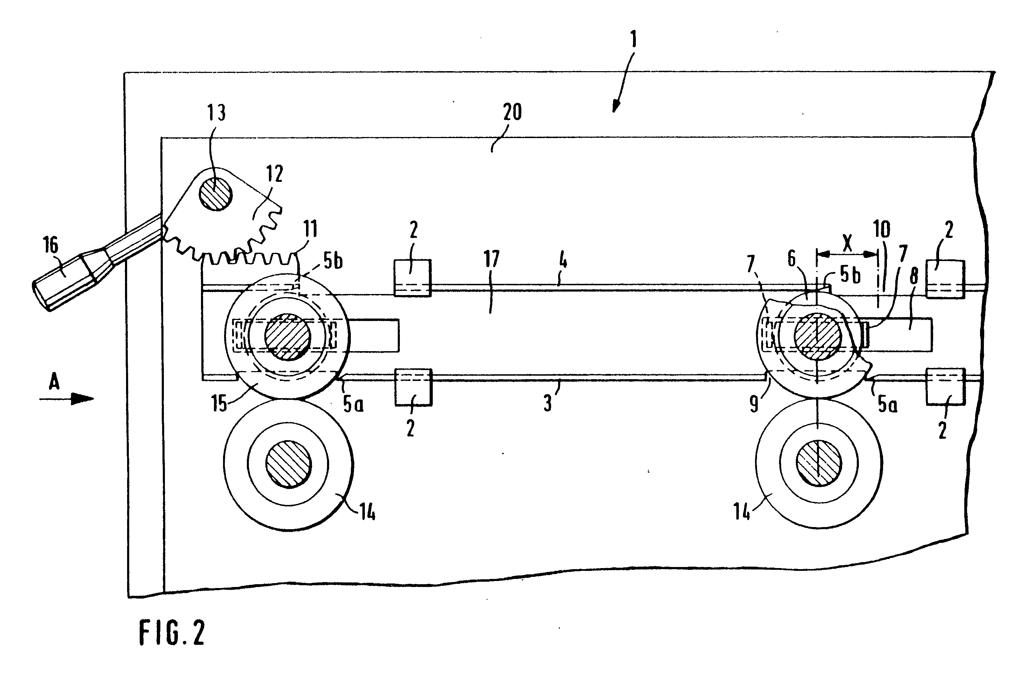

Fig. 2 zeigt in schematischer Darstellung die Andruckstellung der Walzenpaare, in der die oberen Walzen 15 gegen ihre zugehörigen unteren Walzen 14 gepreßt sind. Der untere und der obere Steg 3 und 4 sind jeweils in einer Anzahl von Gleitlagern 2 geführt, bei denen es sich bevorzugt um Kunststofflager handelt. Die Gleitlager 2, 2,... sind an der Innenseite des zugehörigen Seitenschildes 20 angebracht. Die Wand 21 des Schiebeteils 17 besitzt Ausbrüche 8, 8,..., durch welche die spangenförmigen Führungen 7, 7,... ins Innere der Einrichtung 1 hineinragen. Die Ausbrüche 8, 8,... weisen die Form eines gestreckten Rechtecks auf, dessen Längsseite zumindest gleich der Summe aus dem Außendurchmesser eines Kugellagers 6, der Materialstärke der beiden durch die Ausbrüche 8, 8... nach innen weisenden Seitenteile der spangenförmigen Führung und eines Verschiebewegs X des Schiebeteils 17 ist. Der Verschiebeweg eines Schiebeteils 17 ist ein vorgegebener Abstand X, der dem Abstand zwischen den Mittellinien einer unteren Aussparung 9 im unteren Steg 3 und einer zugeordneten oberen Aussparung 10 im oberen Steg 4 des Schiebeteils 17 entspricht. Die gleichgroßen oberen und unteren Aussparungen 9, 9,... sowie 10, 10,... besitzen eine Längsabmessung größer als der Außendurchmesser der Kugellager 6, 6,... Die Höhe H der Wand 21 des Schiebeteils 17 ist kleiner als der Außendurchmesser der Kugellager 6, 6,..., die auf Achsenenden 18, 18,... der oberen Walzen 15, 15,... aufsitzen und diese seitlich begrenzen.

Die Schiebeteile 17, 17 werden aus Blech gestanzt und gebogen, wobei in einem Arbeitsgang die Ausbrüche 8, 8,... in der Wand 21 sowie die unteren und oberen Aussparungen 9, 9,..., 10, 10,... im unteren und oberen Steg 3 und 4 gefertigt werden. Anschließend wird dann der Schiebeteil 17 zu dem U-Profil mit der Wand 21 und den beiden Stegen 3 und 4 gebogen.

Die untere und obere Aussparung 9 bzw. 10 weisen eine abgeschrägte Kante 5a bzw. 5b auf, wobei die abgeschrägten Kanten 5a, 5a,... der unteren Aussparungen 9, 9,... entgegen der Transportrichtung A der Druckplatten gerichtet sind und die abgeschrägten Kanten 5b, 5b,... der oberen Aussparungen 10, 10,... in Transportrichtung A weisen.

Jedes Schiebeteil 17 ist mit einer Zahnstange 11 ausgerüstet, die oberhalb des oberen Stegs 4 an dem einen Ende des Schiebeteils 17 angeordnet ist und parallel zu der Transportrichtung A verläuft. Ein Zahnradsegment 12 befindet sich im Eingriff mit der Zahnstange 11 und ist um eine im Seitenschild 20 gelagerte Achse 13 schwenkbar. Hierzu dient ein Schwenkhebel 16, der mit der Achse 13 des Zahnradsegments 12 verbunden ist. Die Schwenkbewegung des Schwenkhebels 16 wird durch das Ineinandergreifen von Zahnradsegment und Zahnstange in eine Translationsbewegung des Schiebeteils 17 umgesetzt. In Fig. 2 findet sich der Schwenkhebel 16 in seiner unteren Position, das ist die Andruckstellung der Walzenpaare, in der die schrägen Kanten 5b, 5b,... der Aussparungen 10, 10,... des oberen Stegs 4 die Kugellager 6, 6 durch die unteren Aussparungen 9, 9 hindurchdrücken und somit die oberen Walzen 15, 15,... auf die unteren Walzen 14, 14,... anpressen. Da die Kugellager in den spangenförmigen Führungen 7 geführt sind, ist sichergestellt, daß die Kugellager 6, 6 nur vertikal abgesenkt werden, nicht jedoch seitlich ausbrechen können. Die Schrägen der oberen Kanten 5b, 5b,... bilden schiefe Ebenen für die Kugellager 6, 6,... bei der Verschiebung des einzelnen Schiebeteils 17 so daß die Außenringe der Kugellager während des Verschiebens des Schiebeteils 17 auf diesen schiefen Ebenen abrollen und somit die Kugellager 6, 6 nach unten gedrückt werden.

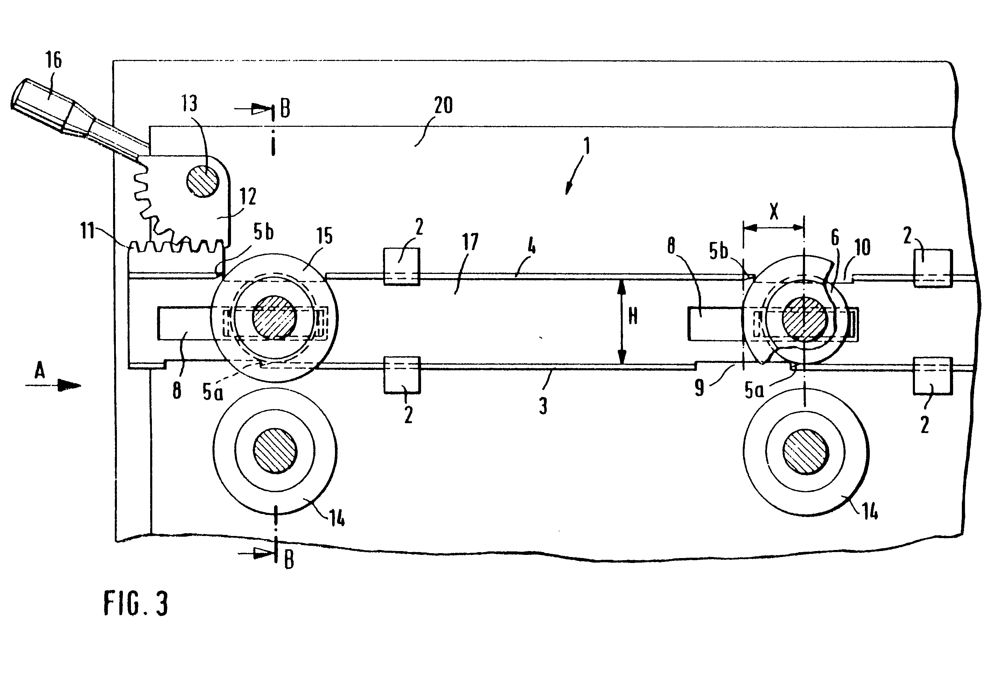

In Fig. 3 ist eine schematische Ansicht der Abhebestellung der Walzenpaare bzw. des Schiebeteils 17 dargestellt. Für übereinstimmende Bauteile in den Fig. 2 und 3 sind die gleichen Bezugszeichen verwendet und die Beschreibung der schon anhand von Fig. 2 erläuterten Bauteile wird nicht wiederholt. Der Schwenkhebel 16 befindet sich in der Abhebestellung in seiner oberen Position, in der das Zahnradsegment 12 in etwa mit dem rechten Ende der Zahnstange 11 im Eingriff steht. Während des Anhebevorgangs wird der Schiebeteil 17 um den Verschiebeweg X entgegen der Transportrichtung A nach links verstellt. Dabei rollen die Kugellager 6, 6,... auf den Schrägen der unteren Kanten 5a, 5a,... in den Aussparungen 9, 9,... des unteren Stegs 3 nach oben ab und werden dadurch in den spangenförmigen Führungen 7 angehoben und somit die oberen Walzen 15 von den unteren Walzen 14 abgehoben. In der Abhebestellung besteht kein Kontakt zwischen den oberen abgeschrägten Kanten 5b, 5b,... der Aussparungen 10 im oberen Steg 4 und den zugehörigen Kugellagern 6, 6,..., die frei durch die oberen Aussparungen 10, 10,... hindurchragen bzw. in diese hineinragen.

Es können somit die Kugellager 6, 6,... der oberen Walzen 15, 15,... durch eine einzige Schwenkbewegung der Schwenkhebel 16, 16 der Schiebeteile 17, 17 angehoben werden, so daß die Bedienung zum Anheben und Absenken der oberen Walzen äußerst vereinfacht ist. Die Schiebeteile 17, 17 verhindern, daß eines der Kugellager auf einer der Seiten der oberen Walzen versehentlich nicht angehoben wird. In der Anhebestellung können die oberen Walzen 15, 15,... leicht aus der Einrichtung 1 entnommen, gereinigt und anschließend wieder eingesetzt werden. Nach der Entnahme der oberen Walzen 15, 15,... sind auch die unteren Walzen 14, 14,..., die lagefest in den Seitenschilden 20, 20 gelagert sind, leicht zugänglich, so daß Wartungs- und Reinigungsarbeiten ohne große Schwierigkeiten vorgenommen werden können.

Im Betriebszustand werden die oberen und unteren Walzen mit einem entsprechenden Druck aneinandergepreßt, um die Druckplatten zu transportieren und die auf den Druckplatten befindliche Restflüssigkeit abzuquetschen. Während längerer Stillstandzeiten, beispielsweise über Nacht oder übers Wochenende, werden die oberen Walzen in die Anhebestellung gebracht, so daß eine Deformierung der Walzen und Verklebungen der Walzen, die zu Beschädigungen der Gummierung führen können, bedingt durch die an den Walzen haftenden Restflüssigkeiten, wie beispielsweise Konservierungsmittel, vermieden werden.

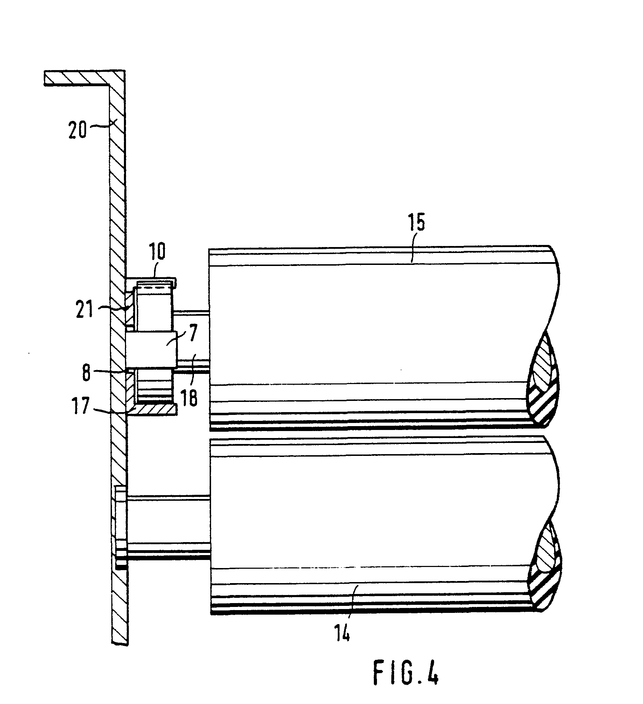

In Fig. 4 ist eine Teilansicht im Schnitt längs der Linien B-B in Fig. 3 gezeigt. Die obere Walze 15 ist von der unteren Walze 14 abgehoben. Auf dem Achsenende 18 der oberen Walze 15 sitzt das Kugellager 6 auf, das mit seiner oberen Umrißkante in die obere Aussparung 10 des Schiebeteils 17 hineinragt, während die untere Umrißkante des Kugellagers 6 nicht in die untere Aussparung 9 hineinragt. Die spangenförmige Führung 7 für das Kugellager 6 umschließt den Außendurchmesser des Kugellagers 6 in etwa der Höhe der Mittellinie der oberen Walze 15 und ist durch die Aussparung 8 in der Wand 21 des Schiebeteils 17 durchgeführt und an der Innenseite des Seitenschildes 20 befestigt. In Fig. 4 ist auch angedeutet, daß die untere Walze 14 lagefest in dem Seitenschild 20 gelagert ist. In Fig. 4 ist von der Einrichtung 1 nur ein linker Abschnitt bzw. Ausschnitt dargestellt, an dem sich ein in gleicher Weise aufgebauter rechter Abschnitt anschließt.

Bei der Ausführungsform gemäß den Figuren 1 bis 4 werden durch die axiale Verschiebung der zwei in Gleitlagern geführten Schiebeteile mit hochkantstehendem U-Profil, gebildet aus dem unteren und oberen Steg die die Aussparungen mit abgeschrägten Kanten enthalten, die oberen Walzen, je nach Stellung, an die unteren Walzen angepreßt oder von diesen abgehoben.

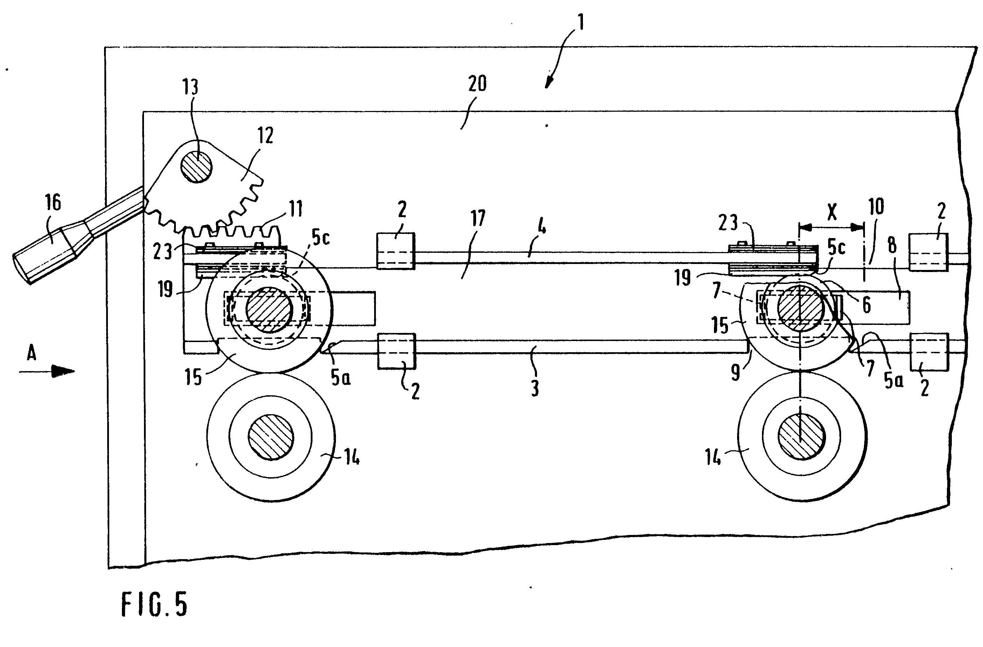

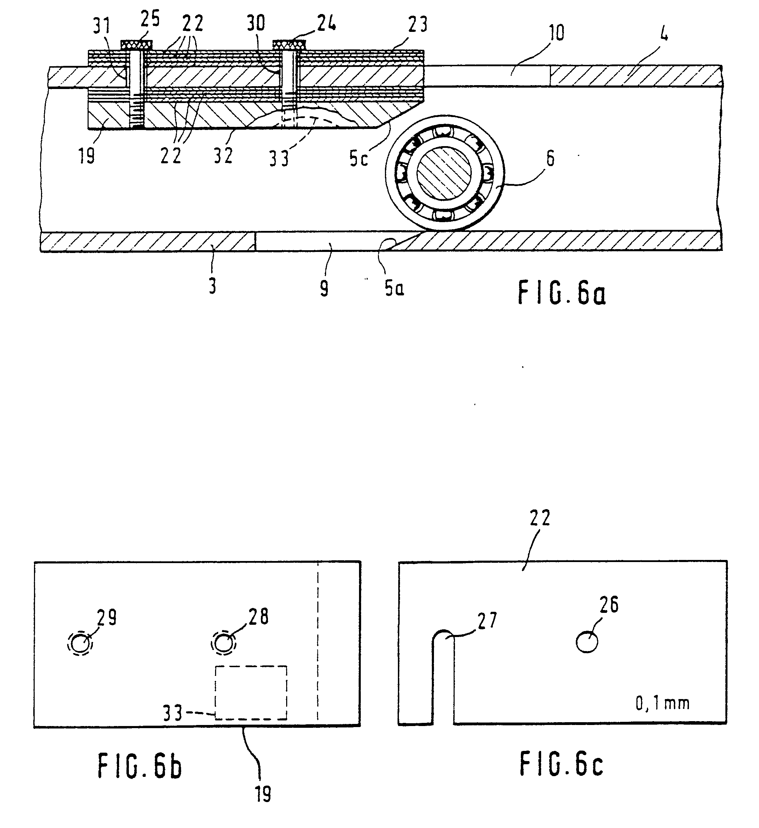

Es besteht die Forderung für Druckplattenentwicklungsgeräte den Anpreßdruck zwischen den oberen und unteren Walzen bzw. den oberen Walzen und einer die Walzenpaare durchlaufenden Druckplatte nach Bedarf wählen zu können, um beispielsweise das Schichtgewicht der auf die Druckplatte aufgetragenen Gummierung einstellen zu können. Wird zu wenig Gummierung aufgetragen, so führt dies im allgemeinen zum Tonen der Druckplatte in der Druckmaschine. Bei der in den Figuren 5 und 6a gezeigten, weiteren Ausführungsform der Einrichtung sind zur Einstellung des Walzenanpreßdrucks Zwischenlagen 22 angrenzend an jede Aussparung 10 des oberen Stegs 4 vorhanden. Die Zwischenlagen 22 befinden sich zwischen der Unterseite des oberen Stegs 4 und der Oberseite eines zugehörigen Formteils 19, das mit einer Schräge 5c ausgerüstet ist.

Die untere Aussparung 9 weist eine abgeschrägte Kante 5a auf, wobei die abgeschrägten Kanten 5a, 5a,... der unteren Aussparungen 9, 9,... entgegen der Transportrichtung A der Druckplatten gerichtet sind, während die Schrägen 5c, 5c,... der Formteile 19 in Transportrichtung A weisen.

Je nach der Anzahl der Zwischenlagen 22 werden die Formteile 19 mit ihren Schrägen 5c und ihren als Anpreßflächen wirkenden Unterseiten 32 beim axialen Verschieben in Transportrichtung A der Schiebeteile 17, 17 mehr oder weniger stark auf die Kugellager 6 drücken und dadurch den Anpreßdruck der oberen Walzen 15 auf die Druckplatte bestimmen. Die Gesamtzahl der Zwischenlagen 22 wird im allgemeinen etwas größer gehalten als für die maximal notwendige Anpressung erforderlich ist, so daß das Verschieben der Schiebeteile in die Anpreßstellung mit maximalem Anpreßdruck erst nach einer Verringerung der Zahl der Zwischenlagen 22 möglich ist. Dadurch wird sichergestellt, daß eine zu starke Anpressung durch zuviele Zwischenlagen, mit den dadurch verursachten Defekten an der Entwicklungseinrichtung, vermieden wird.

Die Zwischenlagen 22 können unterschiedliche Dicken von 0,05 bis 1,0 mm besitzen, bevorzugt werden einheitliche Dicken der Zwischenlagen 22 von 0,1 mm. Jeder Zwischenlage ist in zweckmäßiger Weise ihre Dicke bzw. Stärke ziffern- und dimensionsmäßig eingeprägt, so daß ohne Meßgerät und speziellem Werkzeug auf einfache Weise durch das Wählen der Anzahl der Zwischenlagen und somit der Gesamtstärke der Zwischenlagen 22, die zwischen den Formteilen 19 und dem oberen Steg 4 eingesetzt sind, der jeweils gewünschte Anpreßdruck eingestellt werden kann. Die Einstellung des Anpreßdrucks wird noch näher beschrieben werden.

Auf der Oberseite des oberen Stegs 4 befindet sich ein Vorrat 23 an Zwischenlagen 22, der dem zugehörigen Formteil 19 gegenüberliegt. Die Zwischenlagen 22 jedes Vorrats 23 und die Zwischenlagen 22 zwischen jedem Formteil 19 und dem oberen Steg 4 sind mit dem jeweiligen zugehörigen Formteil 19 verbunden.

Geeignetes Material für die Zwischenlagen 22 ist z. B. rostfreier Stahl.

Die Zwischenlagen und jedes Formteil können auch im Bereich der unteren Walzen, bei lagefesten oberen Walzen, angeordnet sein. Es werden dann die unteren Walzen definiert gegen die oberen Walzen angedrückt.

Das Anpressen und das Abheben der Walzenpaare erfolgt in analoger Weise wie dies anhand der Figuren 2 und 3 voranstehend schon beschrieben wurde.

Fig. 6a zeigt in vergrößerter geschnittener Teilansicht das Formteil 19, den Vorrat 23 an Zwischenlagen 22 und die zwischen dem Formteil 19 und der Unterseite des Stegs 4 vorhandenen Zwischenlagen 22. Im Formteil 19 sind zwei Bohrungen 28, 29 mit Innengewinden vorhanden wie aus Fig. 6b zu ersehen ist. In diese Innengewinde sind zwei Schrauben 24, 25 mit Rändelköpfen eingeschraubt, die Löcher 26, 27 der Zwischenlagen 22 und Löcher 30, 31 des oberen Stegs 4 durchsetzen. Das Formteil 19 wird durch die Schrauben 24, 25 am Steg 4 des U-Profils des Schiebeteils gehalten. In der Unterseite 32 bzw. Anpreßfläche des Formteils 19 ist eine Vertiefung 33 vorhanden, in der das Kugellager 6 der oberen Walze des zugehörigen Walzenpaars 14, 15 (vgl. Fig. 2 und 3) in der Anpreßstellung der Einrichtung 1 mit einem Teil seiner Umfangsfläche zu liegen kommt, um so eine stabile Lage des Kugellagers sicherzustellen. In den Figuren 6b und 6c, die Draufsichten auf das Formteil 19 und eine Zwischenlage 22 wiedergeben, sind die Bohrungen 28, 29 mit den Innengewinden, die Vertiefung 33 sowie das geschlossene Loch 26 und das zur Schmalseite der Zwischenlage 22 hin offene Loch 27 dargestellt. Die beiden Schrauben 24, 25 halten im eingeschraubten Zustand auch die Zwischenlagen 22 des Vorrats 23 fest. Die Zwischenlagen 22 weisen für die eine Schraube 25 das seitlich offene Loch 27 und für die andere Schraube 24 das geschlossene Loch 26 auf.

Die eine Schraube 25 ist bei der Einstellung des Anpreßdrucks unverlierbar gesichert, beispielsweise durch einen Seegerring. Die andere Schraube 24 wird zum Verändern des Anpreßdrucks über die gewählte Anzahl von eingesetzten Zwischenlagen 22 aus dem Formteil 19 herausgeschraubt.

Nach dem Lösen der Schraube 25 werden in der Anpreßstellung der Schiebeteile die Zwischenlagen 22 an jeder Stirnseite der einzustellenden oberen Walze 15 entfernt. Danach werden, ohne daß ein Meßgerät für die Bestimmung des Anpreßdrucks erforderlich ist, soviele Zwischenlagen 22 nahe den beiden Walzenstirnflächen zwischen dem jeweiligen Formteil 19 und dem oberen Steg 4 eingesetzt wie ohne nennenswerte Druckausübung möglich ist. Danach werden die Schiebeteile in die entspannte Position gebracht und aus dem Vorrat 23 Zwischenlagen 22 zum Erreichen des erforderlichen Walzenanpreßdrucks den Zwischenlagen 22 zwischen dem jeweiligen Formteil 19 und dem oberen Steg 4 hinzugefügt.

Zuletzt wird die Schraube 24 eingeschraubt und zusammen mit der gesicherten Schraube 25 festgezogen, um alle Teile wie die Zwischenlagen und das Formteil mit dem Steg 4 unverrückbar zu verbinden. Die notwendige Walzenanpressung der einzelnen Walzenpaare kann als Grundmaß auf den Stegen der Schiebeteile eingeprägt sein. Die Einzelschritte der Einstellung des Anpreßdrucks erfolgen zu beiden Seiten eines Walzenpaars in gleicher Weise, d. h. beide Schiebeteile müssen immer gleichzeitig angepreßt oder entspannt sein.

## Patentansprüche

1. Walzenandruck- und -abhebeeinrichtung mit paarweise horizontal angeordneten oberen und unteren Walzen zum Transport von plattenförmigen Materialien und zum Abquetschen von an den plattenförmigen Materialien haftender Restflüssigkeit, mit je einem an jedem Achsenende jeder oberen Walze bezüglich der unteren Walze anhebbaren und absenkbaren Kugellager, dadurch gekennzeichnet, daß die Kugellager (6, 6,...) in spangenförmigen Führungen (7, 7,...) vertikal geführt sind, die an den Innenseiten von Seitenschilden (20, 20) ortsfest angebracht sind, daß zwei, in Gleitlagern (2, 2,...) geführte Schiebeteile (17, 17) mit hochkantstehendem U-Profil aus unterem und oberem Steg (3, 4) und einer Wand (21), die an den jeweiligen Seitenschild angrenzt und Ausbrüche (8, 8,...) aufweist, durch die die Führungen (7, 7,...) ins Innere der Einrichtung (1) hineinragen, um einen vorgegebenen Abstand (X) hin- und herverschiebbar sind, daß der untere und obere Steg (3, 4) der Schiebeteile Aussparungen (9, 9,... ; 10, 10,...) mit einer abgeschrägten Kante (5a) in jeder unteren Aussparung enthält und daß die unteren Aussparungen (9, 9,...) gegenüber den oberen Aussparungen (10, 10,...) um den vorgegebenen Abstand (X) versetzt sind.

2. Walzenandruck- und -abhebeeinrichtung nach Anspruch 1, dadurch gekennzeichnet, daß jedes Schiebeteil (17, 17) mit einer Zahnstange (11) ausgerüstet ist, die oberhalb des oberen Stegs (4) an dem einen Ende des Schiebeteils angeordnet ist und daß ein Zahnradsegment (12) um eine im Seitenschild (20) gelagerte Achse (13) schwenkbar ist und sich im Eingriff mit der Zahnstange (11) befindet.

3. Walzenandruck- und -abhebeeinrichtung nach Anspruch 2, dadurch gekennzeichnet, daß ein Schwenkhebel (16) mit der Achse (13) des Zahnradsegments (12) verbunden ist und daß die Schwenkbewegung des Schwenkhebels (16) durch das Ineinandergreifen von Zahnradsegment und Zahnstange in eine Translationsbewegung des Schiebeteils (17) umgesetzt wird.

4. Walzenandruck- und -abhebeeinrichtung nach Anspruch 1, dadurch gekennzeichnet, daß der untere und der obere Steg (3, 4) des Schiebeteils (17) jeweils in einer Anzahl von Gleitlagern (2, 2,...) aus Kunststoff geführt sind, die an der Innenseite des zugehörigen Seitenschildes (20) befestigt sind.

5. Walzenandruck- und -abhebeeinrichtung nach Anspruch 1, dadurch gekennzeichnet, daß die abgeschrägten Kanten (5a, 5a,...) der unteren Aussparungen (9, 9,...) entgegen der Transportrichtung (A) der plattenförmigen Materialien gerichtet sind und daß die abgeschrägten Kanten (5b, 5b,...) der oberen Aussparungen (10, 10,...) in Transportrichtung (A) verlaufen.

6. Walzenandruck- und -abhebeeinrichtung nach Anspruch 5, dadurch gekennzeichnet, daß die Schrägen der Kanten (5a, 5a,..., 5b, 5b,....) schiefe Ebenen für die Kugellager (6, 6,...) bei der Verschiebung der Schiebeteile (17, 17) bilden, daß in der Andruckstellung die schrägen Kanten (5b, 5b,....) der Aussparungen (10, 10,....) des oberen Stegs (4) die Kugellager (6, 6,....) durch die unteren Aussparungen (9, 9,....) drücken und die oberen Walzen (15, 15,...) auf die unteren Walzen (14, 14,....) anpressen und daß in der Abhebestellung die schrägen Kanten (5a, 5a,...) der Aussparungen (9, 9,...) des unteren Stegs (3) die Kugellager (6, 6,...) anheben, die frei durch die oberen Aussparungen (10, 10,...) hindurchragen und die oberen von den unteren Walzen abheben.

7. Walzenandruck- und -abhebeeinrichtung nach den Ansprüchen 1 bis 6, dadurch gekennzeichnet, daß die Schiebeteile (17, 17) Stanz- und Biegeteile aus Blech sind.

8. Walzenandruck- und -abhebeeinrichtung nach Anspruch 1, dadurch gekennzeichnet, daß der vorgegebene Abstand (X) gleich dem Abstand zwischen den Mittellinien einer unteren Aussparung (9) und einer zugeordneten oberen Aussparung (10) bzw. gleich dem Verschiebeweg eines Schiebeteils (17) ist.

9. Walzenandruck- und -abhebeeinrichtung nach Anspruch 1, dadurch gekennzeichnet, daß die gleichgroßen Aussparungen (9,10) eine Längsabmessung größer als der Außendurchmesser der Kugellager (6, 6,....) besitzen und daß die Höhe (H) der Wand (21) des Schiebeteils (17) kleiner als der Außendurchmesser der Kugellager (6, 6,...) ist.

10. Walzenandruck- und -abhebeeinrichtung nach Anspruch 1, dadurch gekennzeichnet, daß die Kugellager (6, 6,...) auf den Achsenenden (18, 18,...) der oberen Walzen (15, 15,...) aufsitzen und diese seitlich begrenzen.

11. Walzenandruck- und -abhebeeinrichtung nach Anspruch 1, dadurch gekennzeichnet, daß an dem oberen Steg (4), angrenzend an jede Aussparung (10, 10,...), je ein Formteil (19) mit einer Schräge (5c) lösbar befestigt ist und daß sich zwischen der Unterseite des oberen Stegs (4) und der Oberseite jedes Formteils (19) eine Anzahl von Zwischenlagen (22, 22,...) mit vorgegebenen Dicken befindet.

12. Walzenandruck- und -abhebeeinrichtung nach Anspruch 11, dadurch gekennzeichnet, daß die Zwischenlagen (22) unterschiedliche Dicken von 0,05 bis 1,0 mm haben.

13. Walzenandruck- und -abhebeeinrichtung nach Anspruch 11, dadurch gekennzeichnet, daß die Zwischenlagen (22) eine einheitliche Dicke von 0,1 mm aufweisen.

14. Walzenandruck- und -abhebeeinrichtung nach Anspruch 11, dadurch gekennzeichnet, daß auf der Oberseite des oberen Stegs (4) ein Vorrat (23) von Zwischenlagen jedem Formteil (19) gegenüberliegt und daß jeder Vorrat (23) an Zwischenlagen und die Zwischenlagen (22) zwischen jedem Formteil (19) und dem oberen Steg (4) mit dem zugehörigen Formteil (19) verbunden sind.

15. Walzenandruck- und -abhebeeinrichtung nach Anspruch 12 oder 13, dadurch gekennzeichnet, daß in jede Zwischenlage (22) ihre Dicke ziffern- und dimensionsmäßig eingeprägt ist.

16. Walzenandruck- und -abhebeeinrichtung nach Anspruch 11, dadurch gekennzeichnet, daß die Zwischenlagen (22) aus einem Metall wie rostfreiem Stahl bestehen.

17. Walzenandruck- und -abhebeeinrichtung nach Anspruch 14, dadurch gekennzeichnet, daß jede Zwischenlage (22) ein geschlossenes Loch (26) und ein seitlich offenes Loch (27) aufweist, daß jedes Formteil (19) zwei Bohrungen (28, 29) mit Innengewinden enthält, die mit den Löchern (26, 27) der Zwischenlagen (22) ebenso wie mit zwei entsprechenden Löchern (30, 31) in dem oberen Steg (4) fluchten, und daß Schrauben (24, 25) die Löcher in den Zwischenlagen (22) und im oberen Steg (4) durchsetzen und mit den Innengewinden der Bohrungen (28, 29) des Formteils (19) verschraubt sind.

18. Walzenandruck- und -abhebeeinrichtung nach Anspruch 11, dadurch gekennzeichnet, daß die Unterseite (32) jedes Formteils (19) eine Vertiefung (33) aufweist, in der das Kugellager (6) der oberen Walze (15) des zugehörigen Walzenpaars (14, 15) in der Andruckstellung der Einrichtung (1) mit einem Teil seiner Umfangsfläche zu liegen kommt.

**Claims**

1. A roll pressure and lifting device comprising upper and lower rolls horizontally arranged in pairs, which serve to convey sheet-like materials and to squeeze off any residual liquid adhering to the sheet-like materials, with a ball bearing being provided at each shaft end of each upper roll, which ball bearing can be raised and lowered with respect to the lower roll, characterized in that the ball bearings (6, 6,....) are vertically guided in bracket-type guides (7, 7,....) stationarily mounted to the inside surfaces of side plates (20, 20) ; that two upright, U-shaped slide members (17, 17) can be shifted to and fro by a predetermined distance (X), said slide members (17, 17) being guided in friction bearings (2, 2,....) and comprised of a lower and an upper web (3, 4) and a wall (21) that adjoins the respective side plate and is provided with slots (8, 8,...) through which the guides (7, 7,...) protrude into the interior of the device (1) ; that the lower and the upper webs (3, 4) of each slide member are provided with recesses (9, 9,... ; 10, 10,...), each lower recess having one bevelled edge (5a) ; and that the lower recesses (9, 9,...) are staggered relative to the upper recesses (10, 10,...) by the predetermined distance (X).

2. Roll pressure and lifting device as claimed in Claim 1, characterized in that each slide member (17, 17) is equipped with a gear rack (11) mounted above the upper web (4) at one end of the slide member, and that a gear wheel segment (12) can be swivelled about a shaft (13) supported in the side plate (20), said gear wheel segment (12) engaging said gear rack (11).

3. Roll pressure and lifting device as claimed in Claim 2, characterized in that a swivelling lever (16) is connected with the shaft (13) of the gear wheel segment (12) and the swivelling motion of the swivelling lever (16) is converted into a translation motion of the slide member (17) by the meshing of the gear wheel segment and the gear rack.

4. Roll pressure and lifting device as claimed in Claim 1, characterized in that the lower and the upper web (3, 4) of the slide member (17) are each guided in a plurality of friction gears (2, 2,....) made of a plastic material, which are fastened to the inside surface of the associated side plate (20).

5. Roll pressure and lifting device as claimed in Claim 1, characterized in that the bevelled edges (5a, 5a....) of the lower recesses (9, 9,....) point in a direction opposite the transport direction (A) of the sheet-like materials and the bevelled edges (5b, 5b,...) of the upper recesses (10, 10,....) point in the direction of transport (A).

6. Roll pressure and lifting device as claimed in Claim 5, characterized in that during the shifting of the slide members (17, 17) the bevels of the edges (5a, 5a,... ; 5b, 5b,...) form inclined planes for the ball bearings (6, 6,....), that in the pressure position, the ball bearings (6, 6,...) are pressed through the lower recesses (9, 9,....) by the bevelled edges (5b, 5b,...) of the recesses (10, 10,...) of the upper web (4), such that the upper rolls (15, 15,...) are pressed against the lower rolls (14, 14,...) and that, in the lifting position, the ball bearings (6, 6,....) are lifted by the bevelled edges (5a, 5a,...) of the recesses (9, 9,...) of the lower web (3), such that the ball bearings (6, 6,....) freely project through the upper recesses (10, 10,...) and the upper rolls are lifted off the lower rolls.

7. Roll pressure and lifting device as claimed in Claims 1 to 6, characterized in that the slide members (17, 17) are punched and bent parts of sheet metal.

8. Roll pressure and lifting device as claimed in Claim 1, characterized in that the predetermined distance (X) corresponds to the distance between the center lines of a lower recess (9) and of an associated upper recess (10), i. e. corresponds to the shifting path of a slide member (17).

9. Roll pressure and lifting device as claimed in claim 1, characterized in that the lengths of the recesses (9, 10), which all have the same size, exceed the external diameter of the ball bearings (6, 6,...) and that the height (H) of the wall (21) of the slide member (17) is inferior to the external diameter of the ball bearings (6, 6,...).

10. Roll pressure and lifting device as claimed in Claim 1, characterized in that the ball bearings (6, 6,...) are seated on the shaft ends (18, 18,....) of the upper rolls (15, 15,...) and constitute the lateral ends of said upper rolls (15, 15,...).

11. Roll pressure and lifting device as claimed in Claim 1, characterized in that one shaped part (19) each, having a bevel (5c), is detachably fastened to the upper web (4), adjacent to each recess (10, 10,...) and that a plurality of intermediate sheets (22, 22,...) of defined thicknesses are provided between the underside of the upper web (4) and the upper side of each shaped part (19).

12. Roll pressure and lifting device as claimed in Claim 11, characterized in that the intermediate sheets (22) have different thicknesses of between 0.05 mm and 1.0 mm.

13. Roll pressure and lifting device as claimed in Claim 11, characterized in that the intermediate sheets (22) have uniform thicknesses of 0.1 mm each.

14. Roll pressure and lifting device as claimed in Claim 11, characterized in that on the upper surface of the upper web (4), there is provided a supply (23) of intermediate sheets, which is located opposite each shaped part (19), and that each supply (23) of intermediate sheets and the intermediate sheets (22) present between each shaped part (19) and the upper web (4) are connected with the associated shaped part (19).

15. Roll pressure and lifting device as claimed in Claim 12 or 13, characterized in that each intermediate sheet (22) is provided, by stamping, with a mark indicating its thickness in ciphers and unit of measure.

16. Roll pressure and lifting device as claimed in Claim 11, characterized in that the intermediate sheets (22) are made of a metal, for example, stainless steel.

17. Roll pressure and lifting device as claimed in Claim 14, characterized in that each intermediate sheet (22) is provided with an enclosed hole (26) and a hole (27) which is open toward one side ; that each shaped part (19) is provided with two tapped holes (28, 29), which are in alignment with the holes (26, 27) of the intermediate sheets (22) and with two corresponding holes (30, 31) provided in the upper web (4) ; and that screws (24, 25) cross the holes in the intermediate sheets (22) and in the upper web (4) and are screwed into the internal taps of the holes (28, 29) of the shaped part (19).

18. Roll pressure and lifting device as claimed in Claim 11, characterized in that in the underside (32) of each shaped part (19), there is provided a depression (33) in which a portion of the circumferential surface of the ball bearing (6) of the upper roll (15) of the associated pair of rolls (14, 15) comes to rest when the device (1) is in the pressure position.

**Revendications**

1. Dispositif de mise en pression et hors pression de rouleaux, comprenant des rouleaux supérieurs et inférieurs disposés par paires et horizontalement, qui sont destinés à transporter des produits en forme de plaque et à essorer un liquide résiduel qui demeure associé à ces produits, et comprenant, sur chaque bout d'arbre de chaque rouleau supérieur, un palier à roulement à billes que l'on peut faire s'élever et s'abaisser par rapport au rouleau inférieur, caractérisé en ce que les paliers à roulements à billes (6, 6,...) sont guidés verticalement dans des guides (7, 7,...) en forme de boucle, qui sont montés en position fixe contre les faces intérieures de bâtis latéraux (20, 20), en ce que deux coulisseaux (17, 17) guidés dans des portées lisses (2, 2,....), présentant un profil en U disposé sur chant, composés d'une aile supérieure et d'une aile inférieure (3, 4) et d'une âme (21) qui est contiguë au bâti latéral correspondant et présente des fenêtres (8, 8,....) à travers lesquelles les guides (7, 7,....) font saillie dans le volume intérieur du dispositif (1), peuvent se déplacer en translation alternative sur une distance prédéterminée (X), en ce que l'aile supérieure et l'aile inférieure (3, 4) des coulisseaux présentent chacune des ouvertures (9, 9,... ; 10, 10,...), avec un bord biseauté (5a) dans chaque ouverture inférieure et en ce que les ouvertures inférieures (9, 9,...) sont décalées de la distance prédéterminée (X) par rapport aux ouvertures supérieures (10, 10,...).

2. Dispositif de mise en prise et hors pression de rouleaux selon la revendication 1, caractérisé en ce que chaque coulisseau (17, 17) est équipé d'une crémaillère (11) qui est disposée au-dessus de l'aile supérieure (4), à une des extrémités du coulisseau, et en ce qu'un secteur denté (12) peut pivoter autour d'un axe (13) tourillonné dans le bâti latéral (20) et se trouve en prise avec la crémaillère (11).

3. Dispositif de mise en pression et hors pression de rouleaux selon la revendication 2, caractérisé en ce qu'un levier basculant (16) est fixé à l'axe (13) du secteur denté (12) et en ce que le basculement du levier basculant (16) est transformé en translation du coulisseau (17) par l'engrènement du secteur denté et de la crémaillère.

4. Dispositif de mise en pression et hors pression de rouleaux selon la revendication 1, caractérisé en ce que l'aile supérieure et l'aile inférieure (3, 4) du coulisseau (17) sont guidées chacune dans un certain nombre de portées lisses (2, 2,...) en matière plastique qui sont fixées contre la face intérieure du bâti latéral (20) correspondant.

5. Dispositif de mise en pression et hors pression de rouleaux selon la revendication 1, caractérisé en ce que les bords biseautés (5a, 5a,...) des ouvertures inférieures (9, 9,...) sont orientés en sens inverse du sens de transport (A) des produits en forme de plaque et en ce que les bords biseautés (5b, 5b,...) des ouvertures supérieures (10, 10,...) s'étendent dans le sens du transport (A).

6. Dispositif de mise en pression et hors pression de rouleaux selon la revendication 5, caractérisé en ce que les biseaux des bords (5a, 5a,... ; 5b, 5b,...) forment des plans inclinés pour les paliers à roulements à billes (6, 6,...) lors de la translation des coulisseaux (17, 17), en ce que, dans la position de mise en pression, les bords biseautés (5b, 5b,...) des ouvertures (10, 10,...) de l'aile supérieure (4) pressent les paliers à roulements à billes (6, 6,...) à travers les ouvertures inférieures (9, 9,...) et pressent les rouleaux supérieurs (15, 15,...) sur les rouleaux inférieurs (14, 14,...), et en ce que, dans la position hors pression, les bords biseautés (5a, 5a,...) des ouvertures (9, 9,...) de l'aile inférieure (3) soulèvent les paliers à roulements à billes (6, 6,...) qui traversent librement les ouvertures supérieures (10, 10,...) et écartent les rouleaux supérieurs des rouleaux inférieurs.

7. Dispositif de mise en pression et hors pression de rouleaux selon les revendications 1 à 6, caractérisé en ce que les coulisseaux (17, 17) sont des pièces en tôle découpée et pliée.

8. Dispositif de mise en pression et hors pression de rouleaux selon la revendication 1, caractérisé en ce que la distance prédéterminée (X) est égale à la distance entre les axes d'une ouverture inférieure (9) et d'une ouverture supérieure (10) correspondante, ou égale à la course de translation d'un coulisseau (10).

9. Dispositif de mise en pression et hors pression de rouleaux selon la revendication 1, caractérisé en ce que les ouvertures (9, 10) de mêmes dimensions ont une longueur supérieure au diamètre extérieur des paliers à roulements à billes (6, 6,...) et en ce que la hauteur (H) de l'âme (21) du coulisseau (17) est plus petite que le diamètre extérieur des paliers à roulements à billes (6, 6,...).

10. Dispositif de mise en pression et hors pression de rouleaux selon la revendication 1, caractérisé en ce que les paliers à roulements à billes (6, 6,...) sont montés sur les bouts d'arbres (18, 18,...) des rouleaux supérieurs (15, 15,...) et limitent ces bouts d'arbres latéralement.

11. Dispositif de mise en pression et hors pression de rouleaux selon la revendication 1, caractérisé en ce qu'une pièce de forme (19) munie d'un biseau (5c) est fixée par une liaison démontable à l'aile supérieure (4) dans une position voisine à chaque ouverture (10, 10,...), et en ce que, entre la face inférieure de l'aile supérieure (4) et la face supérieure de chaque pièce de forme (19), se trouvent un certain nombre de cales d'épaisseur (22, 22,...) possédant des épaisseurs prédéterminées.

12. Dispositif de mise en pression et hors pression de rouleaux selon la revendication 11, caractérisé en ce que les cales d'épaisseur (22) ont des épaisseurs différentes, allant de 0,5 à 1,0 mm.

13. Dispositif de mise en pression et hors pression de rouleaux selon la revendication 11, caractérisé en ce que les cales d'épaisseur (22) présentent une épaisseur unique de 0,1 mm.

14. Dispositif de mise en pression et hors pression de rouleaux selon la revendication 11, caractérisé en ce que, sur la face supérieure de l'aile supérieure (4), est disposée une réserve (23) de cales d'épaisseur placée en face de chaque pièce de forme (19) et en ce que chaque réserve (23) de cales d'épaisseur et les cales d'épaisseur (22) placées entre chaque pièce de forme (19) et l'aile supérieure (4), sont assemblés à la pièce de forme (19) correspondante.

15. Dispositif de mise en pression et hors pression de rouleaux selon la revendication 12 ou la revendication 13, caractérisé en ce que chaque cale d'épaisseur (22) est frappée de chiffres indiquant son épaisseur et ses effets.

16. Dispositif de mise en pression et hors pression de rouleaux selon la revendication 11, caractérisé en ce que les cales d'épaisseur (22) sont faites en un métal tel qu'un acier inoxydable.

17. Dispositif de mise en pression et hors pression selon la revendication 14, caractérisé en ce que chaque cale d'épaisseur (22) présente un trou fermé (26) et un trou (27) qui s'ouvre latéralement, en ce que chaque pièce de forme (19) présente deux perçages (28, 29) munis de filetages intérieurs, qui sont alignés sur les trous (26, 27) des cales d'épaisseur (22), ainsi que sur deux trous correspondants (30, 31) de l'aile supérieure (4) et en ce que des vis (24, 25), qui traversent les trous des cales d'épaisseur (22) et de l'aile supérieure (4), sont vissées dans les filetages intérieurs des perçages (28, 29) de la pièce de forme (19).

18. Dispositif de mise en pression et hors pression de rouleaux selon la revendication 11, caractérisé en ce que la face inférieure (32) de chaque pièce de forme (19) présente un évidement (33) dans lequel le palier à roulement à billes (6) du rouleau supérieur (15) de la paire de rouleaux (14, 15) correspondante vient reposer par une partie de sa circonférence dans la position de mise en pression du dispositif (1).

FIG. 1

FIG.2

2

FIG. 3

EP 0 177 873 B1

20

15

10

21

7

8

18

17

14

FIG.4

4

FIG.5

EP 0 177 873 B1

FIG.6a

FIG.6b

FIG.6c

0,1 mm